# EUROPEAN PATENT APPLICATION

(11) **EP 4 310 900 A1**
(43) Date of publication of application: **24.01.2024**
(21) Application number: 22186398.8
(22) Date of filing: 22.07.2022
(51) Int. Cl.: H01L 21/8234, H01L 21/308

(54) **A METHOD FOR CONTROLLING THE WIDTH OF NANO-SIZED FIN-SHAPED FEATURES ON A SEMICONDUCTOR SUBSTRATE**

(71) Applicant: Imec VZW, 3001 Leuven (BE)
(72) Inventor: PETER, Mr. Antony Premkumar, 3001 Leuven (BE); MORIN, Mr. Pierre, 1150 Woluwe-Saint-Pierre (BE); CHAN, Mr. Boon Teik, 3012 Wilsele (BE)
(74) Representative: Patent Department IMEC

(57) **Abstract**

An array of parallel fin-shaped hardmask features (1) is formed on the upper surface of a layer (2) provided on a support substrate (8), a layer (3) of hardmask material is formed at least on the sidewalls of one or more of the hardmask features, thereby increasing the width of said one or more features, i.e., obtaining widened hardmask features. This is followed by patterning the layer onto which the structures are standing, to obtain fin-shaped features having a width determined by the width at the base of the one or more widened hardmask features. According to an embodiment, the formation of the hardmask layer on the sidewalls takes place on one or more hardmask features (1), while other features are covered by a masking layer (5). This approach enables the formation of fin-shaped features (4a,4b) having different widths.

## Description

### Field of the Invention

The present invention is related to semiconductor processing, in particular to the formation of nano-sized fin-shaped features.

### State of the art.

Scale reduction has been an ongoing evolution in semiconductor processing. In particular, the formation of fin-shaped features at ever decreasing scales has been a major field of development, in view of the production of nanometre-sized devices such as finFET's or nano-sheet devices.

Self-aligned multiple patterning techniques are well-known approaches for obtaining arrays of fins having width and pitch in the order of a few nanometres to a few tens of nanometres. These techniques involve the formation of hardmask features commonly referred to as mandrel structures on a stack of layers, forming spacers on the sides of the mandrel structures and removing the mandrel structures relative to the spacers. This process can be repeated several times, with the obtained spacers of a previous iteration serving as mandrel structures for the next iteration, each time decreasing the width and pitch of the obtained features. The spacers obtained in the final iteration are then used as fin-shaped hardmask features for anisotropically etching one or more layers of the stack and obtaining fin-shaped features having the width and pitch of the spacers.

Controlling and engineering the width of the fin-shaped features remains a challenge, however. One approach disclosed for example in patent publication document US8735296B2 is to form additional spacers before removing the mandrel structures. Features of different widths can be obtained by forming additional spacers only on some of the mandrel structures and not on others, by covering a number of mandrels by a mask layer while the additional spacers are deposited. The problem with this approach however is that the material of the additional spacers is added only on one side of the original spacers, leading to an irregularity in the pitch after the removal of the mandrel structures.

A problem that is common to all self-aligned multiple patterning techniques is related to the fact that the spacer material is deposited conformally on and in between the mandrel structures, followed by etching back the spacer material until it remains only on the sidewalls of the mandrel structures. Below a given aspect ratio of the mandrel structures however, this approach no longer allows to control the width of the spacers.

### Summary of the invention

The invention aims to provide a method that overcomes the above-described problems. This aim is achieved by the method according to the appended claims.

According to the method of the invention, an array of parallel fin-shaped hardmask features of nanometre-sized width is formed on the upper surface of a layer provided on a support substrate. Said layer is a semiconductor layer or a stack of layers comprising one or more semiconductor layers. Fin-shaped features are upstanding elongate features extending in a longitudinal direction. The term 'hardmask features' is defined with respect to a surface onto which the features are standing, in that the features enable patterning at least a top layer of said surface relative to the features. The fact that the features act as hardmask features also intrinsically means that the cross-section of the features as seen in a plane perpendicular to said longitudinal direction is either rectangular-shaped or in any case widest at the base of the cross-section. Apart from this however, the exact shape of the cross-section may vary within the scope of the invention. The fin-shaped features have two opposing elongate sidewalls which may be parallel or fully or partially inclined. In the latter case, the sidewalls may be at least partially straight or at least partially curved.

The term nanometre-sized width' refers within the present context to (fin-shaped) features having a width at the base of the cross-section in the order of nanometers, or in the order of tens of nanometres. According to embodiments of the invention, the width at the base of the features is between 5 nm and 30 nm, and the pitch is between 10 nm and 50 nm. The width may vary depending on the technology node which is envisaged. For example, for a 14nm technology node, the gate pitch is about 70 nm (whereas the gate length is about 20-30nm).

Further according to the method of the invention, a layer of hardmask material is formed at least on the sidewalls of one or more of the hardmask features, thereby increasing the width of said one or more features, i.e., obtaining widened hardmask features. This is followed by patterning the layer onto which the structures are standing, to obtain fin-shaped features having a width determined by the width at the base of the one or more widened hardmask features. In the previous sentence, 'determined by' means that the width of the patterned features is a function of the width at the base of the mask features: the higher the width at the base of the mask features, the higher the width of the patterned features. According to preferred embodiments, the patterning step is an anisotropic etching step that transfers the width at the base of the mask features so that the patterned features have essentially the same width as said width at the base of the mask features.

According to an embodiment, one or more hardmask features are widened in the above-described manner, while other hardmask features are covered by a masking layer. This approach enables the formation of fin-shaped features having different widths.

According to one embodiment, the widening of the one or more features is done by performing area selective deposition (ASD) of a layer of hardmask material selectively on the hardmask features, thereby increasing the width of the features. According to another embodiment, a conformal layer of hardmask material is deposited and subsequently removed from the upper surface of the hardmask features and from the surface of the layer onto which the features are standing.

The method is applied to the spacers obtained after the removal of a mandrel structure in a self-aligned multiple patterning technique. The method of the invention enables to increase the width symmetrically on both sides of the spacers. When applying ASD, the increased width of a hardmask feature can be controlled accurately, even for spacers or other hardmask features having a low aspect ratio of 2 or lower.

The invention is in particular related to a method for forming a plurality of parallel fin-shaped features, the method comprising the steps of:
- forming a layer or a stack of layers on a support substrate,
- forming on the upper surface of said layer or of said stack of layers a plurality of fin-shaped hardmask features,
- forming a layer of hardmask material at least on the sidewalls of one or more of said fin-shaped hardmask features, thereby increasing the width of said one or more fin-shaped hardmask features,
- after increasing the width of one or more of the fin-shaped hardmask features, patterning said layer or one or more of the upper layers of the stack with respect to the widened fin-shaped hardmask features, to thereby obtain said plurality of fin-shaped features.

According to an embodiment, prior to the step of forming the layer of hardmask material on said sidewalls, all the fin-shaped hardmask features have the same width.

According to a further embodiment, prior to step of forming the layer of hardmask material on said sidewalls, one or more of the fin-shaped hardmask features are covered by a masking layer, so that forming the hardmask material takes place only on the hardmask features which are not covered by said masking layer, and the masking layer is removed prior to the patterning step.

According to an embodiment, the fin-shaped hardmask features are spacers obtained by a self-aligned multiple patterning technique.

According to an embodiment, the material of the outer surface of said features is different from the material of said upper surface of the layer or stack of layers and the layer of hardmask material is applied by area selective deposition, so that the layer covers the sidewalls and the upper surface of the fin-shaped hardmask features, while no hardmask material is formed on the surface of said layer or stack of layers.

According to another embodiment, a layer of said hardmask material is formed conformally on the topography defined by the fin-shaped features and the surface of said layer or stack of layers, followed by removing said hardmask material from the top of the features and from the surface of said layer or stack of layers, while said layer of hardmask material remains on the sidewalls of the features. The removal of said hardmask material may be done by etching back the material on the upper surface of the fin-shaped features and on the surface of said layer or stack of layers.

According to an embodiment, the layer onto which the hardmask features are standing is a layer of silicon oxide or amorphous silicon, the hardmask features are formed of silicon nitride, and the layer of hardmask material formed at least on the sidewalls of the one or more fin-shaped hardmask features is also silicon nitride.

According to an embodiment, the step of patterning said layer or one or more of the upper layers of the stack with respect to the widened hardmask features is done by anisotropic etching.

### Brief description of the figures

Figures 1a to 1d illustrate the method of the invention according to a first embodiment applied to a number of fin-shaped hardmask features.
Figures 2a to 2d illustrate the method of the invention according to the first embodiment but applied to only part of the hardmask features.
Figures 3a to 3d illustrates an alternative embodiment of the method of the invention.
Figures 4a to 4i illustrate the application of the method according to the first embodiment of the invention, in a process sequence for forming parallel gate structures in a semiconductor fabrication process.

### Detailed description of preferred embodiments of the invention

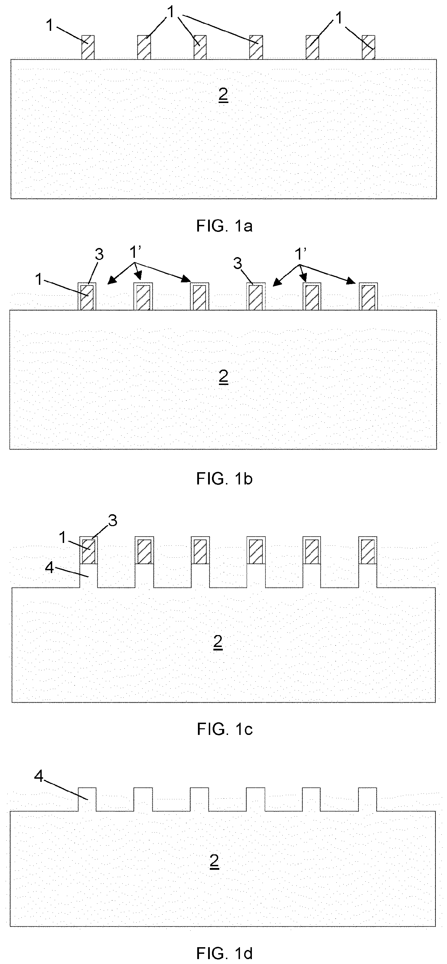

Figure 1a shows a regular array of mutually parallel fin-shaped hardmask features 1 of nanometre-sized width and rectangular cross-section on the upper surface of a layer 2.

The features 1 may be formed in any way known in the art, for example as spacers obtained in one of the iteration steps of a self-aligned multiple patterning technique, even though in that case the upper surface of the feature will normally be more rounded as will be shown in a further embodiment. The features 1 may be uniformly formed of a single material or they may comprise a uniform outer layer consisting of a single material. The layer 2 is formed on a support substrate not shown in the drawing. The support substrate may for example be a silicon process wafer of diameter 200 mm or 300 mm. The layer 2 may consist of a stack of layers with the features 1 standing on the planar surface of the top layer of the stack. Even though the use of a single uniform layer 2 is not excluded from the scope of the invention, in most self-aligned multiple patterning scenarios, the layer 2 will effectively be a stack of layers. An example of a layer stack and the application of the invention to such a stack will be given later in this description.

According to one embodiment of the invention, and as illustrated in Figure 1b, a layer 3 of hardmask material is selectively deposited on the fin-shaped hardmask features 1. The deposition may be done by area selective deposition (ASD), a technique known as such, wherein material is supplied to a substrate comprising surface portions and/or structures thereon which are formed of different materials, and wherein the supplied material is formed on one material and not on another, without covering said another material by a mask. The technique uses deposition methods which rely on selective surface reactions, like atomic layer deposition (ALD) and chemical vapor deposition (CVD). The selectivity could theoretically be 100% in which case one deposition step, for example one ALD step, is sufficient to deposit layer 3 at a required thickness. In most circumstances however, the selectivity is less than 100% which means that after a given deposition time, the deposited material begins to form also on the areas where the deposition is not wanted (said another material). The thin layer of formed material in these areas is then removed by a brief etch process, after which a next deposition cycle follows. This is repeated a number of times until a layer of a desired thickness is formed in one or more areas, while none of the deposited material is formed outside these areas. In the present context, such a cyclic approach is to be considered as a form of selective area deposition (ASD).

According to exemplary and non-limiting embodiments of the invention, the fin-shaped hardmask features 1 are formed of Si₃N₄ and the upper surface of layer 2 is formed of SiO₂ or amorphous Silicon (aSi). A layer 3 of Si₃N₄ may be formed on the features 2 by ASD realized by cyclic ALD depositions of Si₃N₄ followed by etch steps as described above. As the application of ASD in this cyclic manner on these materials is known as such, the conditions to be applied during the ALD depositions and the etch steps are known to the skilled person and therefore not described here in detail.

As a result of the ASD process, and as illustrated in Figure 1b, the width of the features 1 is increased by twice the thickness of the selectively deposited layer 3 while the height is increased by a single thickness of said layer 3. The result is the formation of widened and heightened features 1'. The thickness of the layer 3 may be in the order of a few nanometers, for example between 5 and 10 nm.

The deposited hardmask material may be the same material as the material of the surface of the features 1 themselves or it may be different. For example, it is also possible to form a layer 3 of SiCO on Si₃N₄ hardmask features standing on a SiO₂ or amorphous Si surface, by area selective deposition. The deposited material of layer 3 is referred to as a hardmask material, given the fact that after the selective deposition step, the features 1' having now an increased width due to the selective deposition, are used as hardmask features for a subsequent patterning step.

This patterning step is illustrated in Figure 1c. The width of the widened features 1' is transferred to the underlying layer 2 by anisotropic etching. After the removal of the hardmask features 1' illustrated in Figure 1d, fin-shaped features 4 formed of the material of layer 2 are obtained. The width of these features 4 is essentially equal to the increased width of the hardmask features 1' following the selective deposition. By tuning the thickness of the selectively deposited layers 3, the eventual width of the features 4 can thereby be engineered accurately and regardless of the aspect ratio of the original features 1, which is a particular advantage of the use of area selective deposition. Indeed, as the material is deposited selectively on the features 1, no etch step is required that removes a significant layer of the material from the areas between the features 1. A reliable width increase is thereby obtainable even for features having a low aspect ratio. The invention is however not limited to the use of ASD, as will be explained further in the description.

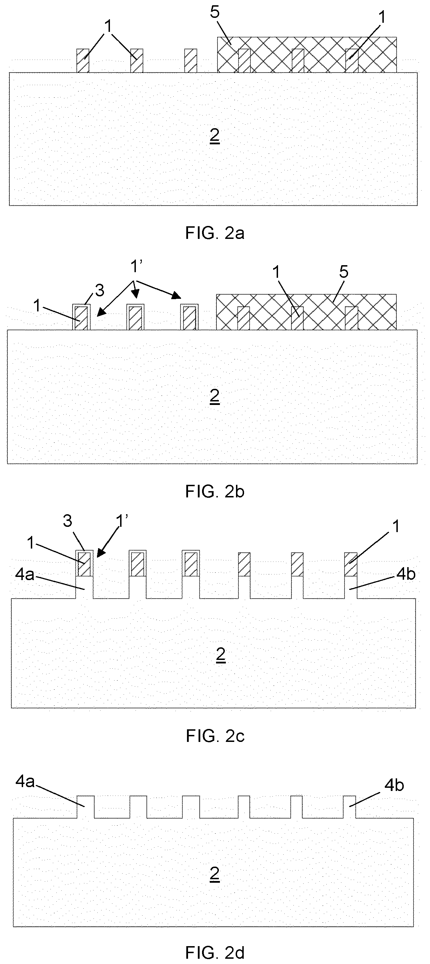

Figures 2a to 2d illustrate an embodiment of the method of the invention, wherein the area selective deposition is applied on some of the fin-shaped hardmask features 1 while other features 1 are covered by a masking layer 5 (see Figures 2a and 2b). The masking layer 5 may be formed first on the whole of the surface of layer 2, and subsequently patterned by lithography and etching so that it is left only on selected areas of the surface. After the area selective deposition step for forming the layers 3 on the exposed features 1, the masking layer 5 is removed and the layer 2 is etched (see Figure 2c), leading to fin-shaped features 4a and 4b (Figure 2d) having different widths.

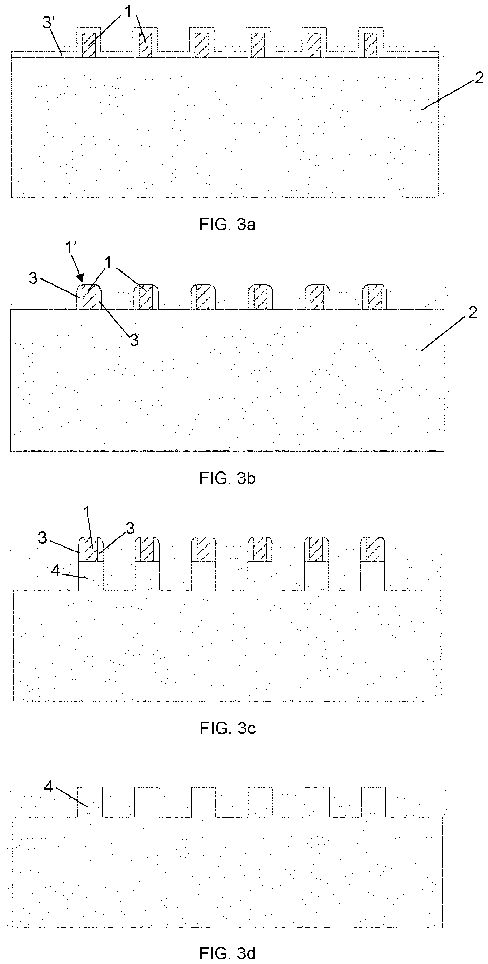

As stated above, the invention is not limited to applying ASD for widening the fin-shaped hardmask features 1. Figures 3a to 3d illustrate an alternative embodiment. As seen in Figure 3a, a conformal layer 3' of hardmask material is deposited on the topography defined by the hardmask features 1 and the surface of layer 2, 'conformal' meaning that the layer 3 follows the topography. After this, an etching step is applied (Figure 3b), wherein the layer 3' is removed from the top of the features 1 and from the areas of the surface of layer 2 in between the features 1, while the original thickness of the conformal layer 3' or at least a significant portion thereof remains on the sidewalls in the form of sidewall spacers 3. This type of etch process is well-known for example from the above-described multiple patterning techniques where it is used to create spacers at the sides of a mandrel structure. As seen in Figure 3b, the result is a widening of the original hardmask features 1, so that widened hardmask features 1' are obtained. As illustrated in Figures 3c and 3d, anisotropic etching is applied to obtain the patterned features 4, in the same manner as in the first embodiment. The same material combinations described in relation to the first embodiment can be used : features 1 formed of Si₃N₄ on a SiO₂ or amorphous Si surface, with the conformal layer 3' formed also of Si₃N₄. The conformal layer 3' can be applied by atomic layer deposition (ALD) for example. Compared to ASD this method requires an increased number of etch and cleaning steps.

The embodiment of Figures 3a to 3d can be applied also on a group of hardmask features while covering the other features by a masking layer, in the same way as described with respect to Figures 2a to 2d, in order to obtain patterned features 4a and 4b having different widths.

The embodiment shown in Figures 3a to 3d requires a minimum aspect ratio of the fin-shaped hardmask features 1. If the aspect ratio is too small, the width of the spacers 3 is difficult to control or in the extreme case, hardly any spacers remain on the side of the features after the etch step. Therefore, the aspect ratio of the fin-shaped hardmask features 1 in this embodiment is preferably higher than 2, more preferably between 2 and 4.

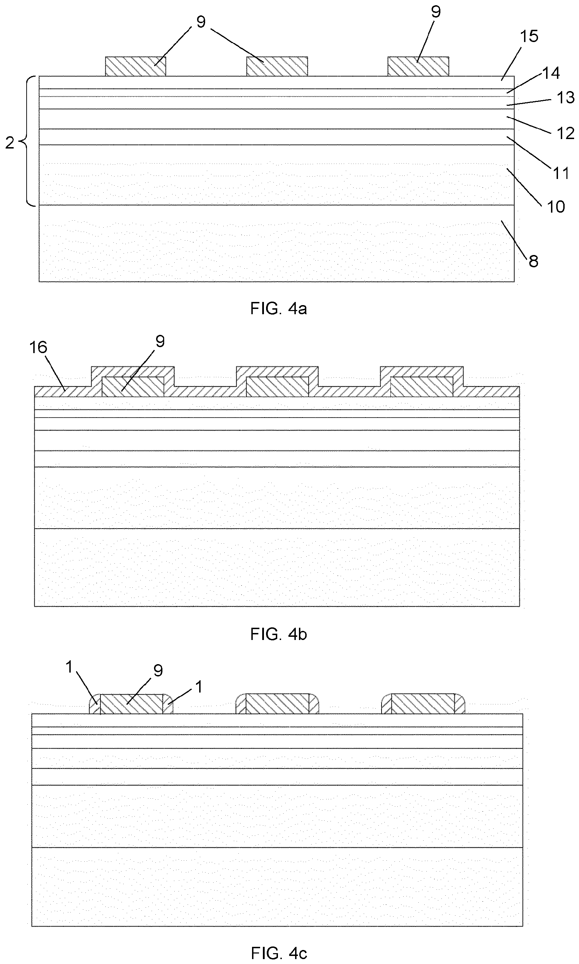

An example of an application of the method of the invention is now given in a more realistic semiconductor processing context. Figure 4a shows a stack of layers 2 with an array of mandrel structures 9 on the upper surface thereof, in a configuration suitable for forming amorphous silicon gate structures. The layer materials and dimensions cited hereafter are given merely by way of example and with the aim of describing a practical implementation of the method of the invention. The mandrel structures 9 may be formed of amorphous carbon and have a thickness of for example between 35 and 50 nm, at a pitch between 80 to 100 nm. They are formed on a stack 2 of layers that is present on a silicon process wafer 8. The stack comprises from the bottom to the top a number of layers defined as follows: a layer 10 of amorphous Si, a layer 11 of silicon nitride Si₃N₄ , a layer 12 of silicon oxide SiO₂, a layer 13 of amorphous carbon , a layer 14 of Si₃N₄ and a layer 15 of amorphous Si.

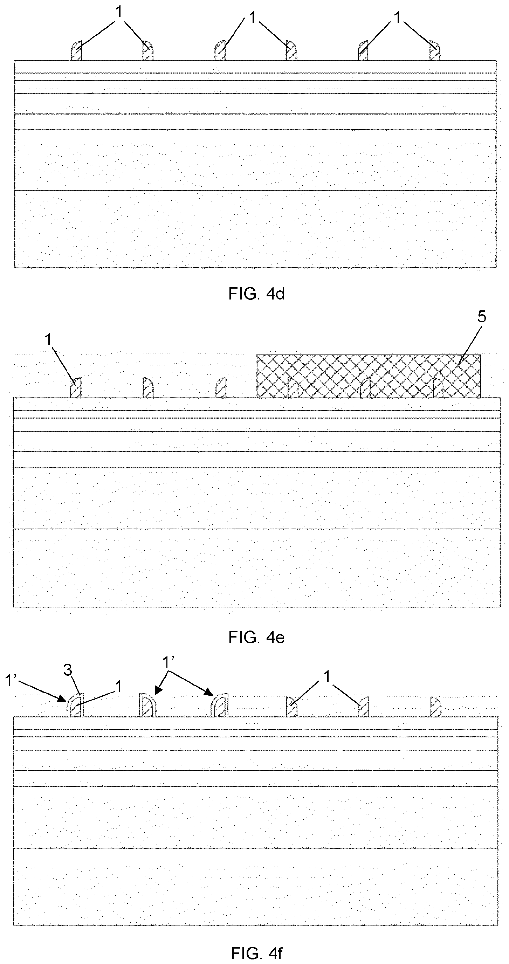

With reference to Figure 4b, a layer 16 of Si₃N₄ is deposited conformally on the topography defined by the mandrel structures 9 and the surface of layer 15, i.e., the layer 16 follows said topography. Layer 16 may for example be deposited by atomic layer deposition (ALD). With reference to Figure 4c, the Si₃N₄ layer 16 is etched back from the level surfaces, leaving spacers 1 on the sidewalls of the mandrel structures 9, after which the mandrel structures 9 are removed relatively to the spacers 1, as illustrated in Figure 4d. The thickness of the Si₃N₄ layer 16 is such that the distance between each pair of adjacent spacers 1 is constant, i.e. the array of spacers 1 is a regular array having a constant pitch. Etch recipes and methods for etching back the silicon nitride layer 16 are well known in the art of self-aligned multiple patterning and are therefore not described here in detail.

The method of the invention is applied to this array of spacers 1, i.e. the spacers are the 'hardmask features' 1 stated above and in the appended claims. First a masking layer 5 is applied on one half (a subpart) of the spacers 1, as illustrated in Figure 4e, and in analogy with the embodiment of Figures 2a to 2d. The masking layer 5 may for example be a layer of spin-on carbon. Then the area selective deposition step is applied in accordance with the above-described first embodiment of the invention and the masking layer 5 is removed, as illustrated in Figure 4f. The width and height of the exposed spacers 1 (i.e., not covered by the masking layer 5) has been increased, resulting in widened spacers 1'. The material deposited by ASD (using cyclically applied ALD steps and etching steps) is Si₃N₄, which forms a layer 3 on the Si₃N₄ spacers 1 while no Si₃N₄ is formed on the amorphous Si layer 15.

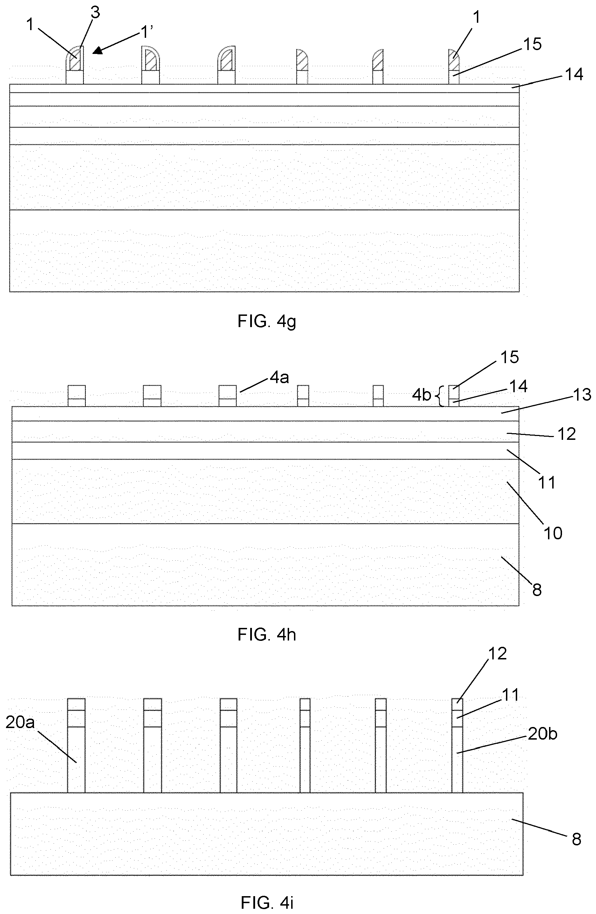

The spacers 1' and 1 are used as hardmask features for anisotropically etching the amorphous silicon layer 15 and the Si₃N₄ layer 14, as shown in Figures 4g and 4h. The hardmask features 1 and 1' are consumed by the etchant that removes the Si₃N₄ layer 14. Possibly, any remnants of the features 1 and 1' are removed relative to the fin-shaped features 4a and 4b obtained by the anisotropic etch.

With reference to Figure 4i, these fin-shaped features 4a and 4b are themselves used as hardmask features for anisotropically etching the amorphous carbon layer 13, the SiO₂ layer 12, the second Si₃N₄ layer 11 and eventually the amorphous silicon layer 10, resulting in an array of amorphous Si fin-shaped features 20a and 20b suitable for use as gate structures having different widths. By using the method according to embodiments of the present invention for example multiple gate length fabrication is simplified compared to prior art multiple patterning schemes such as for example SAQP patterning schemes.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for forming a plurality of parallel fin-shaped features (4), the method comprising the steps of:
- forming a layer or a stack of layers (2) on a support substrate (8),
- forming on the upper surface of said layer or of the stack of layers (2) a plurality of fin-shaped hardmask features (1),
- forming a layer (3) of hardmask material at least on the sidewalls of one or more of the fin-shaped hardmask features, thereby increasing the width of the one or more fin-shaped hardmask features (1),
- after increasing the width of the one or more of the fin-shaped hardmask features (1), patterning the layer (2) or one or more of the upper layers of the stack of layers (2) with respect to the widened fin-shaped hardmask features (1'), to thereby obtain the plurality of parallel fin-shaped features (4).

2. The method according to claim 1, wherein prior to the step of forming the layer (3) of hardmask material on the sidewalls, all the fin-shaped hardmask features (1) have the same width.

3. The method according to claim 1 or 2, wherein prior to the step of forming the layer of hardmask material on the sidewalls, one or more of the fin-shaped hardmask features (1) are covered by a masking layer (5), so that forming the layer (3) of hardmask material takes place only on the fin-shaped hardmask features (1) which are not covered by the masking layer (5), and wherein the masking layer (5) is removed prior to the patterning step.

4. The method according to any one of the preceding claims, wherein the fin-shaped hardmask features (1) are spacers obtained by a self-aligned multiple patterning technique.

5. The method according to any one of the preceding claims, wherein the material of the outer surface of the fin-shaped hardmask features (1) is different from the material of the upper surface of the layer or stack of layers (2) and wherein the layer (3) of hardmask material is applied by area selective deposition, so that the layer (3) covers the sidewalls and the upper surface of the fin-shaped hardmask features (1), while no hardmask material is formed on the upper surface of the layer or stack of layers (2).

6. The method according to any one of claims 1 to 4, wherein a layer (3') of the hardmask material is formed conformally on the topography defined by the fin-shaped hardmask features (1) and the upper surface of the layer or stack of layers (2), followed by removing the hardmask material from the top of the features and from the upper surface of the layer or stack of layers (2), while the layer (3) of hardmask material remains on the sidewalls of the fin-shaped hardmask features (1).

7. The method according to claim 6, wherein the removal of the hardmask material is done by etching back the material on the upper surface of the fin-shaped hardmask features (1) and on the upper surface of the layer or stack of layers (2).

8. The method according to any one of the preceding claims, wherein the layer or the upper layer of the stack of layers (2) onto which the fin-shaped hardmask features (1) are standing is a layer of silicon oxide or amorphous silicon, the fin-shaped hardmask features (1) are formed of silicon nitride, and the layer (3) of hardmask material formed at least on the sidewalls of the one or more fin-shaped hardmask features (1) is also silicon nitride.

9. The method according to any one of the preceding claims, wherein the step of patterning the layer (2) or one or more of the upper layers of the stack of layers (2) with respect to the widened fin-shaped hardmask features (1') is done by anisotropic etching.
